# EUROPÄISCHE PATENTSCHRIFT

(11) **EP 3 807 214 B1**
(45) Veröffentlichungstag und Bekanntmachung des Hinweises auf die Patenterteilung: **25.05.2022**
(21) Anmeldenummer: 18746902.8
(22) Anmeldetag: 25.07.2018
(51) Int. Cl.: C01B 33/02, H01M 4/134, C30B 29/06, C09D 11/037, H01M 4/1395, H01M 4/38, H01M 10/0525

(54) **THERMISCHE BEHANDLUNG VON SILIZIUMPARTIKELN**
THERMAL TREATMENT OF SILICON PARTICLES
TRAITEMENT THERMIQUE DE PARTICULES DE SILICIUM

(43) Veröffentlichungstag der Anmeldung: 21.04.2021
(73) Patentinhaber: Wacker Chemie AG, 81737 München (DE)
(72) Erfinder: JANTKE, Dominik, 84489 Burghausen (DE); MAURER, Robert, 81373 München (DE)
(74) Vertreter: Ege, Markus
(86) Internationale Anmeldenummer: PCT/EP2018/070234
(87) Internationale Veröffentlichungsnummer: WO 2020/020458

(56) Entgegenhaltungen:
- WO-A1-2018/077389
- WO-A1-2018/082789
- JP-B2- 4 396 858

## Beschreibung

Die Erfindung betrifft Verfahren zur thermischen Behandlung von Siliziumpartikeln

Wiederaufladbare Lithiumionen-Batterien sind heute die praxistauglichen elektrochemischen Energiespeicher mit den höchsten gravimetrischen Energiedichten. Eine besonders hohe theoretische Materialkapazität weist Silizium (4200 mAh/g) auf und ist deswegen als Aktivmaterial für Anoden von Lithiumionen-Batterien besonders geeignet. Die Herstellung von Anoden erfolgt über Anodentinten, in denen die einzelnen Bestandteile des Anodenmaterials in einem Lösungsmittel dispergiert sind. Im industriellen Maßstab wird als Lösungsmittel für die Anodentinten aus ökonomischen und ökologischen Gründen zumeist Wasser eingesetzt. Silizium ist gegenüber Wasser sehr reaktiv und wird bei Kontakt mit Wasser unter Bildung von Siliziumoxiden und Wasserstoff oxidiert. Wasserstofffreisetzung führt in der Verarbeitung der Anodentinten zu erheblichen Schwierigkeiten. Beispielsweise können solche Tinten auf Grund eingeschlossener Gasblasen inhomogene Elektrodenbeschichtungen ergeben. Zudem macht die Wasserstoffbildung aufwändige sicherheitstechnische Schutzmaßnahmen erforderlich. Eine unerwünschte Oxidation von Silizium in der Anodentinte führt letztlich auch zur Verringerung des Siliziumanteils in der Anode, was die Kapazität der Lithiumionen-Batterie reduziert.

Lithiumionen-Batterien mit Siliziumpartikel enthaltenden Anodenmaterialien sind beispielsweise aus der DE102015215415 bekannt. DE102015215415 beschreibt hierfür Siliziumpartikel mit einer volumengewichteten Partikelgrößenverteilung von d₁₀ ≥ 0,2 µm und d₉₀ ≤ 20,0 µm sowie einer Breite d₉₀-d₁₀ von ≤ 15 µm. Die EP1313158 empfiehlt für solche Zwecke dagegen Siliziumpartikel mit durchschnittlichen Partikelgrößen von 100 bis 500 nm, die hergestellt wurden durch Mahlen und anschließende oxidative Behandlung mit Sauerstoff-haltigen Gasen bei 80 bis 450°C oder in Inertgasen mit geringerem Sauerstoffgehalt bei 80 bis 900°C. Größere Partikelgrößen sind laut EP1313158 nachteilig für die Coulomb-Effizienz entsprechender Batterien.

Um die Gasentwicklung bei der wässrigen Verarbeitung von Siliziumpartikeln und damit verbundene Probleme während der Verarbeitung zu reduzieren, wurde vielfach empfohlen, die Oberfläche von Siliziumpartikeln zu oxidieren, wie beispielsweise beschrieben in KR1020150034563. Die WO 2018/077389 empfiehlt, die oxidative Behandlung von Siliziumpartikeln mit einem Sauerstoff-haltigen Gas bei 80 bis 900°C durchzuführen, um die Partikel beständiger gegenüber wässrigen Medien zu machen. In EP1102340 wird gelehrt, Siliziumpartikel für Lithium-Ionen-Batterien durch Mahlen in Magerluft herzustellen.

Touidjine, Journal of The Electrochemical Society, 2015, 162, Seiten A1466 bis A1475, befasst sich mit der Reduzierung der Wasserstoffbildung bei Kontakt von gemahlenen Siliziumpartikeln mit Wasser. Hierzu lehrt Touidjine, die Siliziumpartikel mittels Wasser oder an Luft bei erhöhter Temperatur teilweise zu oxidieren. Die zur Oxidation eingesetzten Siliziumpartikel haben einen SiO₂-Gehalt von 9 Gew.-% und nach Luftoxidation einen SiO₂-Gehalt von 11 Gew.-%, je bezogen auf das Gesamtgewicht der Siliziumpartikel. Die Siliziumpartikel haben durchschnittliche Partikelgrößen von 150 nm und liegen in Form von Aggregaten vor. Die zur Oxidation eingesetzten Siliziumpartikel haben eine spezifische Oberfläche BET von 14 m²/g, die im Zuge der Luftoxidation von Touidjine reduziert wird. Touidjine empfiehlt den Einsatz solcher partiell oxidierten Siliziumpartikel zur Herstellung von wässrigen Anodentinten für Anoden von Lithiumionen-Batterien.

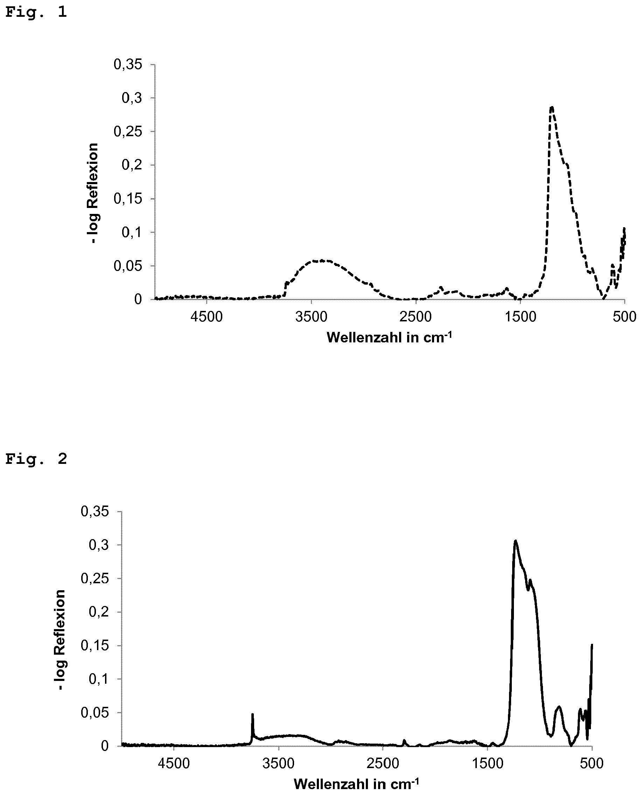

Tichapondwa, Propellants, Explosives, Pyrotechnics, 2013, 38, Seiten 48 bis 55, diskutiert wässrige Silizium-Dispersionen als Vorstufen für retardierte pyrotechnische Zünder. Zur Unterdrückung der Wasserstoffbildung bei Kontakt der Siliziumpartikel mit Wasser empfiehlt Tichapondwa, die Oberfläche der Siliziumpartikel durch Oxidation bei erhöhter Temperatur an Luft mit einer Siliziumoxidschutzschicht zu versehen. Die der Oxidation unterzogenen Siliziumpartikel haben einen durchschnittlichen Partikeldurchmesser von 2,06 µm, eine BET-Oberfläche von 9,68 m²/g und sind bereits zu 13% oxidiert, bezogen auf das Silizium, und liegen aggregiert vor. Die oxidierten Siliziumpartikel von Tichapondwa sind weiterhin aggregiert, wie durch Laserstreuung mit und ohne Ultraschallbehandlung gezeigt wurde. Aus der Figur 1 des Artikels von Tichapondwa geht hervor, dass dessen oxidierte, aggregierte Siliziumpartikel in Wasser allerdings noch erhebliche Mengen an Wasserstoff freisetzen - und dies trotz der sehr hohen Oxidanteile.

Die oxidative Behandlung von Siliziumpartikeln führt bei deren Einsatz in Lithium-Ionen-Batterien generell zu einer Verringerung der Kapazität und kann auch einen initialen Verbrauch an Lithium oder eine Isolierung der Siliziumpartikel bewirken. Darüber hinaus können bei der Oxidation von Siliziumpartikeln mit Sauerstoff verfahrenstechnische Probleme auftreten, wie beispielsweise unkontrollierte Überoxidation oder Staub-Explosionen, welche besondere Sicherheitsmaßnahmen erforderlich machen. Etwaige native Oxidschichten, wie sie etwa beim Mahlen oder Lagern von Siliziumpartikeln gebildeten werden, vermögen Siliziumpartikel nicht hinreichend in der Weise zu passivieren, dass bei einer Verarbeitung der Siliziumpartikel in wässrigem Medien, insbesondere in Anodentinten für Lithium-Ionen-Batterien, die Bildung von Wasserstoff unterdrückt wird. Mahlverfahren zur Herstellung von Siliziumpartikeln sind beispielsweise in der WO2018/082789 und der WO2018/082794 beschrieben.

JP4396858 B2 beschreibt Siliciumpartikel mit einer durchschnittlichen Partikelgröße von 10 µm bis 10 mm und einem Sauerstoffgehalt von ≤ 0,24 Gew.-%.

Vor diesem Hintergrund bestand weiterhin die Aufgabe, Maßnahmen zur Verfügung zu stellen, mit denen die bei der Verarbeitung von Siliziumpartikeln in wässrigen Medien auftretenden Probleme gelöst werden, insbesondere bei der Verarbeitung der Materialien zu Elektroden, und gleichzeitig eine Reduktion der Kapazität bzw. ein Aufbau einer dicken, isolierenden Schicht unterbunden werden kann. Dieses Verfahren soll insbesondere sicher und kontrolliert durchgeführt werden können.

Gegenstand der Erfindung sind Verfahren zur Herstellung von Siliziumpartikeln, die volumengewichtete Partikelgrößenverteilungen mit Durchmesser-Perzentilen d₅₀ von 1,0 µm bis 10,0 µm und einen Sauerstoffgehalt von 0,1 bis 5 Gew.-%, bezogen auf das Gesamtgewicht der Siliziumpartikel, haben, indem
1) Silizium gemahlen wird unter Bildung von Siliziumpartikeln, wobei das Mahlen in oxidativer Atmosphäre oder in oxidativem Medium erfolgt und/oder
   die mittels Mahlen erhaltenen Siliziumpartikel einer oxidativen Atmosphäre ausgesetzt werden, und
2) die in Schritt 1) erhaltenen Siliziumpartikel bei einer Temperatur von 300°C bis 1100°C in Inertgasatmosphäre oder im Vakuum thermisch behandelt werden.

Auf Grund ihrer erfindungsgemäßen Herstellung unterscheiden sich die Siliziumpartikel aus Schritt 2) strukturell von den als Edukt für die thermische Behandlung eingesetzten Siliziumpartikeln aus Schritt 1). Dies äußert sich beispielsweise dadurch, dass die Siliziumpartikel aus Schritt 2) in Wasser bei Raumtemperatur im Allgemeinen keine oder eine im Vergleich zu den Siliziumpartikeln aus Schritt 1) eine zumindest weitaus geringere und/oder verzögerte Wasserstoffentwicklung zeigen und daher eine Verarbeitung in wässrigen Tintenformulierungen ohne oder mit weniger Aufschäumen und somit die Herstellung von zumindest homogeneren Anodenbeschichtungen ermöglichen.

Die Temperatur für die thermische Behandlung der Siliziumpartikel in Schritt 2) beträgt vorzugsweise 400°C bis 1080°C, mehr bevorzugt 500°C bis 1060°C, besonders bevorzugt 600°C bis 1040°C, noch mehr bevorzugt 700°C bis 1030°C und am meisten bevorzugt 750°C bis 1020°C.

Die Inertgasatmosphäre kann als Inertgas beispielsweise Stickstoff oder Edelgase, wie Helium, Neon, Argon oder Xenon, insbesondere Stickstoff oder Argon enthalten. Die Inertgasatmosphäre enthält vorzugsweise ≥ 95 Vol.-%, besonders bevorzugt ≥ 99 Vol.-%, mehr bevorzugt ≥ 99,5 Vol.-%, noch mehr bevorzugt ≥ 99,9 Vol.-% und am meisten bevorzugt ≥ 99,99 Vol.-% Inertgas, bezogen auf das Gesamtvolumen des Inertgases.

Als weitere Bestandteile kann die Inertgasatmosphäre beispielsweise reduktive Gase, wie Wasserstoff oder Hydrazin, oder sonstige, in kommerziell verfügbaren, technischen Gasen üblicherweise enthaltene Bestandteile enthalten. Der Anteil der reduktiven Gase beträgt vorzugsweise ≤ 5 Vol.-%, besonders bevorzugt ≤ 1 Vol.-% und am meisten bevorzugt ≤ 0,1 Vol.-%. Sauerstoff und/oder Wasser ist in der Inertgasatmosphäre zu vorzugsweise ≤ 1 Vol.-%, besonders bevorzugt ≤ 0,1 Vol.-%, noch mehr bevorzugt ≤ 0,01 Vol.-% und am meisten bevorzugt ≤ 0,001 Vol.-% enthalten. Am allermeisten bevorzugt enthält die Inertgasatmosphäre keinen Sauerstoff und kein Wasser. Der Anteil von Gasen oder Kohlenstoff-Precursoren, wie sie üblicherweise in CVD-Verfahren (Chemical-Vapor-Deposition, chemische Gasphasenabscheidung) Einsatz finden, insbesondere aliphatischen, ungesättigten oder aromatischen Kohlenwasserstoffen, mit vorzugsweise 1 bis 10 Kohlenstoffatomen, wie Methan, Ethan, Propan, Ethylen, Acetylen, Benzol, Toluol, Styrol, Ethylbenzol, ist vorzugsweise ≤ 1 Vol.-%, besonders bevorzugt ≤ 0,1 Vol.-% und noch mehr bevorzugt ≤ 0,01 Vol.-%. Am meisten bevorzugt enthält die Inertgasatmosphäre keine Kohlenstoff-Precursoren. Die Angaben in Gew.-% beziehen sich auf das Gesamtvolumen des Inertgases.

Der Druck bei der thermischen Behandlung in Inertgasatmosphäre in Schritt 2) kann beispielsweise 0,5 bis 2 bar, vorzugsweise 0,8 bis 1,5 bar und mehr bevorzugt 1 atm betragen. Besonders bevorzugt wird bei Umgebungsdruck gearbeitet.

Alternativ kann die thermische Behandlung in Schritt 2) auch im Vakuum ausgeführt werden. Bei dieser Ausführungsform beträgt der Druck vorzugsweise ≤ 0,5 bar, mehr bevorzugt ≤ 0,1 bar und besonders bevorzugt ≤ 20 mbar. Hierbei besteht die etwaige Gasphase vorzugsweise aus der oben beschriebenen Inertgasatmosphäre.

Die thermische Behandlung in Schritt 2) wird im Allgemeinen in Abwesenheit von Lösungsmittel, beispielsweise Wasser oder Alkohole, wie Methanol oder Ethanol, durchgeführt. Bei der thermischen Behandlung ist im Allgemeinen keine flüssige Phase zugegen.

Vorzugsweise werden Siliziumpartikel aus Schritt 1) unmittelbar nach ihrer Herstellung mittels Mahlen und gegebenenfalls anschließendem Lagern, insbesondere ohne vorherige chemische Umsetzung, der thermischen Behandlung in Schritt 2) unterworfen.

Die Siliziumpartikel werden vor oder während der thermischen Behandlung in Schritt 2) allgemein nicht mit Kohlenstoff oder Polymeren beschichtet. In Schritt 2) sind also allgemein keine Kohlenstoff-haltigen Verbindungen zugegen, wie Polymere oder Kohlenstoff-Precursoren, insbesondere nicht die oben genannten Kohlenstoff-Precursoren. Vor oder während der Durchführung von Schritt 2) erfolgt also allgemein keine Umsetzung von Siliziumpartikeln mit Kohlenstoff-haltigen Verbindungen. In Schritt 2) beträgt der Anteil von Siliziumpartikeln vorzugsweise ≥ 90 Gew.-%, besonders bevorzugt ≥ 95 Gew.-% und am meisten bevorzugt ≥ 99 Gew.-%, bezogen auf das Gesamtgewicht aus Siliziumpartikeln und etwaigen Kohlenstoff-haltigen Verbindungen.

Die thermische Behandlung in Schritt 2) erfolgt vorzugsweise in Gegenwart von ausschließlich Siliziumpartikeln und gegebenenfalls Inertgasatmosphäre.

In Schritt 2) erfolgt im Allgemeinen auch kein Mahlen der Siliziumpartikel.

Die Inertgasatmosphäre kann sich während der thermischen Behandlung in Schritt 2) statisch über den Siliziumpartikeln befinden oder kann durch den Reaktor, in dem die thermische Behandlung erfolgt, durchgeleitet werden.

Die Dauer der thermischen Behandlung in Schritt 2) kann über einen breiten Bereich variieren und ist auch davon abhängig, welche Temperatur für die thermische Behandlung gewählt wird. Eine im Einzelfall zweckerfüllende Temperatur und Dauer der thermischen Behandlung kann vom Fachmann anhand weniger orientierender Versuche leicht ermittelt werden. Die Dauer der thermischen Behandlung oder die mittlere Verweilzeit der Siliziumpartikel im Reaktor beträgt vorzugsweise 1 Minute bis 16 Stunden, besonders bevorzugt 3 Minuten bis 6 Stunden und am meisten bevorzugt 10 Minuten bis 2 Stunden.

Die thermische Behandlung kann in herkömmlichen, statischen oder dynamischen, Reaktoren erfolgen, wie beispielsweise in Rohröfen, Drehrohröfen, Wirbelschichtreaktoren oder Fließbettreaktoren. Besonders bevorzugt sind Kalzinieröfen und Drehrohröfen.

Das Verfahren kann kontinuierlich oder diskontinuierlich betrieben werden.

Die in Schritt 2) eingesetzten Siliziumpartikel haben volumengewichtete Partikelgrößenverteilungen mit Durchmesser-Perzentilen d₅₀ von vorzugsweise 1,0 bis 8,0 µm, besonders bevorzugt 2,0 bis 7,0 µm und am meisten bevorzugt 3,0 bis 6,0 µm.

Die volumengewichtete Partikelgrößenverteilung der Siliziumpartikel aus Schritt 1) weist Durchmesser-Perzentile d₁₀ von vorzugsweise 0,5 µm bis 10 µm, besonders bevorzugt 0,5 µm bis 5,0 µm und am meisten bevorzugt 0,5 µm bis 3,0 µm auf.

Die volumengewichtete Partikelgrößenverteilung der Siliziumpartikel aus Schritt 1) weist Durchmesser-Perzentile d₉₀ von vorzugsweise µm 2,0 bis 20,0 µm, besonders bevorzugt 3,0 bis 15,0 µm und am meisten bevorzugt 5,0 µm bis 10,0 µm auf.

Die volumengewichtete Partikelgrößenverteilung der Siliziumpartikel aus Schritt 1) hat eine Breite d₉₀-d₁₀ von vorzugsweise ≤ 20,0 µm, mehr bevorzugt ≤ 15,0 µm, noch mehr bevorzugt ≤ 12,0 µm, besonders bevorzugt ≤ 10,0 µm und am meisten bevorzugt ≤ 7,0 µm.

Die volumengewichtete Partikelgrößenverteilung der Siliziumpartikel ist bestimmbar durch statische Laserstreuung unter Anwendung des Mie-Modells mit dem Messgerät Horiba LA 950 mit Alkoholen, wie beispielsweise Ethanol oder Isopropanol, oder vorzugsweise Wasser als Dispergiermedium für die Siliziumpartikel.

Die Siliziumpartikel aus Schritt 1) basieren vorzugsweise auf elementarem Silizium. Unter elementarem Silizium ist hochreines, polykristallines Silizium, mit geringem Anteil an Fremdatomen (wie beispielsweise B, P, As), gezielt mit Fremdatomen dotiertes Silizium (wie beispielsweise B, P, As), beispielsweise Solarsilizium, aber auch Silizium aus metallurgischer Verarbeitung, welches elementare Verunreinigung (wie beispielsweise Fe, Al, Ca, Cu, Zr, Sn, Co, Ni, Cr, Ti, C) aufweisen kann, zu verstehen.

Die Siliziumpartikel aus Schritt 1) enthalten vorzugsweise ≥ 95 Gew.-%, mehr bevorzugt ≥ 98 Gew.-%, besonders bevorzugt ≥ 99 Gew.-% und am meisten bevorzugt ≥ 99,9 Gew.-% Silizium. Die Angaben in Gew.-% beziehen sich auf das Gesamtgewicht der Siliziumpartikel aus Schritt 1), insbesondere auf das Gesamtgewicht der Siliziumpartikel aus Schritt 1) abzüglich deren Sauerstoff-Anteil. Der erfindungsgemäße Anteil von Silizium an den Siliziumpartikeln aus Schritt 1) ist bestimmbar mittels ICP (inductively coupled plasma)-Emissionspektrometrie gemäß EN ISO 11885:2009 mit dem Messgerät Optima 7300 DV, Fa. Perkin Elmer.

Die Siliziumpartikel aus Schritt 1) enthalten im Allgemeinen Siliziumoxid. Siliziumoxid befindet sich vorzugsweise an der Oberfläche der Siliziumpartikel. Eine Oxidschicht kann die Oberfläche der Siliziumpartikel vollständig oder teilweise bedecken. Siliziumoxid, insbesondere in Form von Oxidschichten, kann generell beim Mahlen von Silizium in oxidativer Atmosphäre oder in oxidativem Medium entstehen oder bei Kontakt der mittels Mahlen erhaltenen Siliziumpartikel mit einer oxidativen Atmosphäre gebildet werden, wie beispielsweise während des Lagerns der Siliziumpartikel. Solche Oxidschichten werden auch als native Oxidschichten bezeichnet.

Die Siliziumpartikel aus Schritt 1) tragen im Allgemeinen an ihrer Oberfläche eine Oxidschicht, insbesondere eine Siliziumoxid-Schicht, mit einer Dicke von vorzugsweise 0,5 bis 30 nm, besonders bevorzugt 1 bis 10 nm und am meisten bevorzugt 1 bis 5 nm (Bestimmungsmethode: beispielsweise HR-TEM (hochauflösende Transmissionselektronenmikroskopie)).

Die Siliziumpartikel aus Schritt 1) enthalten vorzugsweise 0,1 bis 5,0 Gew.-%, mehr bevorzugt 0,1 bis 2 Gew.-%, besonders bevorzugt 0,1 bis 1,5 Gew.-% und am meisten bevorzugt 0,2 bis 0,8 Gew.-% Sauerstoff, bezogen auf das Gesamtgewicht der Siliziumpartikel aus Schritt 1) (Bestimmung mit dem Leco TCH-600 Analysator).

Die Siliziumpartikel aus Schritt 1) sind vorzugsweise nicht aggregiert, besonders bevorzugt nicht agglomeriert.

Aggregiert bedeutet, dass sphärische oder weitestgehend sphärische Primärpartikel, wie sie beispielsweise zunächst in Gasphasenprozessen bei der Herstellung von Siliziumpartikeln gebildet werden, zu Aggregaten zusammengewachsen, beispielsweise über kovalente Bindungen verknüpft sind. Primärpartikel oder Aggregate können Agglomerate bilden. Agglomerate sind eine lose Zusammenballung von Aggregaten oder Primärpartikeln. Agglomerate können beispielsweise mit Knet- oder Dispergierverfahren leicht wieder in die Primärpartikel oder Aggregate aufgespalten werden. Aggregate lassen sich mit diesen Verfahren nicht oder nur in geringem Umfang in die Primärpartikel zerlegen. Aggregate und Agglomerate haben im Allgemeinen ganz andere Sphärizitäten und Kornformen als die bevorzugten Siliziumpartikel und sind im Allgemeinen nicht sphärisch. Das Vorliegen von Siliziumpartikeln in Form von Aggregaten oder Agglomeraten kann beispielsweise mittels herkömmlicher Raster-Elektronen-Mikroskopie (REM) sichtbar gemacht werden. Statische Lichtstreuungsmethoden zur Bestimmung der Teilchengrößenverteilungen oder Partikeldurchmessern von Siliziumpartikeln können dagegen nicht zwischen Aggregaten oder Agglomeraten unterscheiden.

Die BET-Oberflächen der Siliziumpartikel aus Schritt 1) betragen vorzugsweise 0,2 bis 8,0 m²/g, besonders bevorzugt 0,5 bis 5,0 m²/g und am meisten bevorzugt 1,0 bis 5,0 m²/g (Bestimmung gemäß DIN 66131 (mit Stickstoff)).

Die Siliziumpartikel aus Schritt 1) haben eine Sphärizität von vorzugsweise 0,3 ≥ ψ ≤ 0,9, besonders bevorzugt 0,5 ≥ ψ ≤ 0,85 und am meisten bevorzugt 0,65 ≤ ψ ≤ 0,85. Siliziumpartikel mit solchen Sphärizitäten sind insbesondere nach Mahlverfahren erhältlich. Die Sphärizität ψ ist das Verhältnis aus der Oberfläche einer Kugel gleichen Volumens zur tatsächlichen Oberfläche eines Körpers (Definition von Wadell). Sphärizitäten können beispielsweise aus herkömmlichen REM-Aufnahmen ermittelt werden.

Die Siliziumpartikel aus Schritt 1) haben vorzugsweise scharfkantige Bruchflächen oder sind vorzugsweise splitterförmig.

Die Siliziumpartikel aus Schritt 1) sind mittels Mahlen von Silizium zugänglich. Das Mahlen kann beispielsweise nach Nassoder insbesondere nach Trocken-Mahlverfahren erfolgen. Es finden vorzugsweise Planetenkugelmühlen, Rührwerkskugelmühlen oder insbesondere Strahlmühlen, wie Gegenstrahl- oder Prallmühlen, Einsatz.

Mit Mahlverfahren werden allgemein nicht-aggregierte Siliziumpartikel erhalten. Dagegen führt die Herstellung von Siliziumpartikeln mittels Gasphasenprozessen, wie Gasphasenabscheidung, bekanntermaßen zu aggregierten Siliziumpartikeln.

Das Mahlen von Silizium kann in oxidativer Atmosphäre erfolgen. Insbesondere Trocken-Mahlverfahren werden in oxidativer Atmosphäre durchgeführt. Eine oxidative Atmosphäre kann als oxidative Gase, beispielsweise Kohlendioxid, Stickoxide, Schwefeldioxid, Ozon, Peroxide, insbesondere Sauerstoff oder Wasserdampf enthalten. Die oxidative Atmosphäre enthält oxidative Gase zu vorzugsweise 1 bis 100 Vol.%, besonders bevorzugt 5 bis 80 Vol.% und noch mehr bevorzugt 10 bis 50 Vol.%. Die oxidative Atmosphäre kann auch Inertgase enthalten, wie beispielsweise Stickstoff, Edelgase oder sonstige Inertgase. Inertgase sind zu vorzugsweise ≤ 99 Vol.%, besonders bevorzugt 20 bis 95 Vol.% und am meisten bevorzugt 50 bis 90 Vol.% enthalten. Die oxidative Atmosphäre kann auch Verunreinigungen oder sonstige gasförmige Komponenten, vorzugsweise zu ≤ 10 Vol.%, besonders bevorzugt ≤ 5 Vol.% und am meisten bevorzugt ≤ 1 Vol.% enthalten. Die Angaben in Vol.% beziehen sich jeweils auf das Gesamtvolumen der oxidativen Atmosphäre. Am meisten bevorzugt enthält die oxidative Atmosphäre Luft. Die oxidative Atmosphäre enthält oxidative Gase mit einem Partialdruck von vorzugsweise 0,3 bis 200 bar, mehr bevorzugt 0,5 bis 100 bar, besonders bevorzugt 0,4 bis 10 bar und am meisten bevorzugt 0,6 bis 4 bar. Die oxidative Atmosphäre hat einen Druck von vorzugsweise 0,7 bis 200 bar, besonders bevorzugt von 1 bis 40 bar und am meisten bevorzugt 1,5 bis 10 bar. Entsprechende Verfahren sind beispielsweise beschrieben in der WO 2018/082794 oder WO 2018/082794.

Alternativ kann das Mahlen von Silizium auch in oxidativem Medium erfolgen. Insbesondere Nass-Mahlverfahren werden in oxidativem Medium durchgeführt. Hierbei ist Silizium vorzugsweise im oxidativen Medium suspendiert. Beim oxidativen Medium kann es sich beispielsweise um anorganische Flüssigkeiten, wie Wasser, oder organische Flüssigkeiten, wie aliphatische oder aromatische Kohlenwasserstoffe, Ester oder insbesondere Alkohole handeln. Beispiele für Alkohole sind Methanol, Butanol, insbesondere Ethanol und Propanol. Organische Flüssigkeiten enthalten vorzugsweise weniger als 5 Gew.-% Wasser, besonders bevorzugt weniger als 1 Gew.-% Wasser. Entsprechende Verfahren sind beispielsweise in der WO 2017/025346 beschrieben.

Die mittels Mahlen erhaltenen Siliziumpartikel können in Schritt 1) auch einer oxidativen Atmosphäre ausgesetzt werden, beispielsweise im Zuge des Lagerns der Siliziumpartikel. Hierbei kann die oxidative Atmosphäre zusammengesetzt sein, wie oben beschrieben. Bevorzugte oxidative Gase sind Kohlendioxid, Stickoxide, Ozon, insbesondere Sauerstoff oder Wasserdampf. Am meisten bevorzugt enthält die oxidative Atmosphäre Luft. Die oxidative Atmosphäre hat hierbei einen Druck von vorzugsweise 0,7 bis 2 bar, besonders bevorzugt 1 atm oder Umgebungsdruck. Alternativ kann das Lagern auch unter Inertgasatmosphäre erfolgen, insbesondere unter der oben beschriebenen Inertgasatmosphäre. Das Lagern der Siliziumpartikel erfolgt bei Temperaturen von vorzugsweise 0°C bis 50°C, besonders bevorzugt 10°C bis 40°C und am meisten bevorzugt 15°C und 30°C. Die Siliziumpartikel können beispielsweise für bis zu mehrere Stunden, ein oder mehrere Tage, ein oder mehrere Wochen oder ein oder mehrere Jahre gelagert werden.

Die in Schritt 2) erhaltenen Siliziumpartikel weisen bezüglich ihrer volumengewichteten Partikelgrößenverteilungen d₅₀, d₁₀, d₉₀ und d₉₀-d₁₀, Sphärizitäten, BET-Oberflächen, Gew.-%-Anteile an Silizium und/oder Gew.-%-Anteile an Gew.-% Sauerstoff oder etwaiger sonstiger Bestandteile, Oxidschichtdicke vorzugsweise die Eigenschaften auf, wie weiter oben für die Siliziumpartikel aus Schritt 1) angegeben sind. Dies trifft auch auf die Angaben zur Partikelform zu, wie beispielsweise nicht-aggregierte Partikel oder Partikel mit scharfkantigen Bruchflächen oder splitterförmige Partikel.

Die in Schritt 2) erhaltenen Siliziumpartikel und die zu ihrer Herstellung eingesetzten Siliziumpartikel aus Schritt 1) unterscheiden sich in ihrem Gehalt an Sauerstoff und/oder Silizium um vorzugsweise ≤ 0,2 Gew.-%, besonders bevorzugt ≤ 0,1 Gew.-% und am meisten bevorzugt ≤ 0,05 Gew.-%, bezogen auf das Gesamtgewicht der Siliziumpartikel (Bestimmung des Siliziumgehalts: mittels ICP wie oben angegeben; Bestimmung des Sauerstoffgehalts: wie weiter unten unter dieser Überschrift beschrieben).

Ohne an eine Theorie gebunden zu sein, kann angenommen werden, dass im Zuge der erfindungsgemäßen thermischen Behandlung in Schritt 2) die Oberflächenstruktur der Siliziumpartikel verändert wird. Dies äußert sich beispielsweise in der Ausgestaltung der Oxidschicht der Siliziumpartikel. So ist die Anzahl der SiOH-Gruppen der in Schritt 2) erhaltenen Siliziumpartikel, insbesondere die Anzahl von SiOH-Gruppen pro Flächeneinheit der Oberfläche (SiOH-Gruppen-Dichte) der Siliziumpartikel aus Schritt 2), vorzugsweise kleiner als die SiOH-Gruppen-Dichte der Siliziumpartikel aus Schritt 1), wie anhand von DRIFT Spektren (diffuse reflectance infrared fourier transform spectroscopy) festgestellt werden kann. So ist im DRIFT-Spektrum eines Siliziumpartikels aus Schritt 2) das Verhältnis des Maximums des negativen logarithmischen Reflexionssignals von SiOH, insbesondere im Bereich von 3300 cm⁻¹ bis 3500 cm⁻¹, zum Maximum des negativen logarithmischen Reflexionssignals von SiO₂, insbesondere im Bereich von 1150 cm⁻¹ bis 1250 cm⁻¹, vorzugsweise ≤ 0,2, besonders bevorzugt ≤ 0,15, noch mehr bevorzugt ≤ 0,1 und am meisten bevorzugt < 0,08 (Bestimmungsmethode: siehe weiter unten unter der Überschrift "Messung und Auswertung von DRIFT Spektren"). Das vorgenannte Verhältnis ist vorzugsweise ≥ 0,001, besonders bevorzugt ≥ 0,01 und am meisten bevorzugt ≥ 0,03. Mit der erfindungsgemäßen Ausgestaltung dieses Parameters kann die Beständigkeit von Siliziumpartikeln in Wasser verbessert werden.

Die Tintenformulierungen basieren vorzugsweise auf einer Mischung umfassend erfindungsgemäß hergestellte Siliziumpartikel aus Schritt 2), ein oder mehrere Bindemittel, gegebenenfalls Graphit, gegebenenfalls ein oder mehrere weitere elektrisch leitende Komponenten und gegebenenfalls ein oder mehrere Additive.

Bevorzugte Bindemittel sind Polyacrylsäure oder deren Alkali-, insbesondere Lithium- oder Natrium-Salze, Polyvinylalkohole, Cellulose oder Cellulosederivate, Polyvinylidenfluorid, Polytetrafluorethylen, Polyolefine, Polyimide, insbesondere Polyamidimide, oder thermoplastische Elastomere, insbesondere Ethylen-Propylen-Dien-Terpolymere. Besonders bevorzugt sind Polyacrylsäure, Polymethacrylsäure oder Cellulose-Derivate, insbesondere Polyacrylsäure oder deren Lithium oder Natrium-Salze.

Als Graphit kann allgemein natürlicher oder synthetischer Graphit eingesetzt werden. Die Graphitpartikel haben bevorzugt eine volumengewichtete Partikelgrößenverteilung zwischen den Durchmesser-Perzentilen d₁₀ > 0,2 µm und d₉₀ < 200 µm.

Bevorzugte weitere elektrisch leitende Komponenten sind Leitruß, Kohlenstoff-Nanoröhrchen oder metallische Partikel, beispielsweise Kupfer.

Beispiele für Additive sind Porenbildner, Dispergiermittel, Verlaufsmittel oder Dotiermittel, beispielsweise elementares Lithium.

Bevorzugte Rezepturen für die Tintenformulierungen der Lithiumionen-Batterien enthalten vorzugsweise 5 bis 95 Gew.-%, insbesondere 60 bis 85 Gew.-% erfindungsgemäß hergestellte Siliziumpartikel aus Schritt 2); 0 bis 40 Gew.-%, insbesondere 0 bis 20 Gew.-% weitere elektrisch leitende Komponenten; 0 bis 80 Gew.-%, insbesondere 5 bis 30 Gew.-% Graphit; 0 bis 25 Gew.-%, insbesondere 5 bis 15 Gew.-% Bindemittel; und gegebenenfalls 0 bis 80 Gew.-%, insbesondere 0,1 bis 5 Gew.-% Additive; wobei sich die Angaben in Gew.-% auf das Gesamtgewicht der Tintenformulierung beziehen und sich die Anteile aller Bestandteile der Tintenformulierung auf 100 Gew.-% aufsummieren.

Die Verarbeitung der Bestandteile der Tintenformulierung zu einer Anodentinte bzw. -paste erfolgt vorzugsweise in Wasser oder in einem wässrigen Lösungsmittel. Ein wässriges Lösungsmittel enthält allgemein Wasser und ein oder mehrere organische Lösungsmittel. Beispiele für organische Lösungsmittel sind Tetrahydrofuran, N-Methylpyrrolidon, N-Ethylpyrrolidon, Aceton, Dimethylsulfoxid, Dimethylacetamid oder Ethanol. Der Anteil der organischen Lösungsmittel ist vorzugsweise ≤ 50 Vol.-%, mehr bevorzugt ≤ 20 Vol.-% und besonders bevorzugt ≤ 10 Vol.-%, bezogen auf das Gesamtvolumen der wässrigen Lösungsmittel. Am meisten bevorzugt enthält das Wasser kein organisches Lösungsmittel.

Zur Herstellung der Tintenformulierungen können herkömmliche Vorrichtungen Einsatz finden, wie beispielsweise Rotor-Stator-Maschinen, Dissolvermischer, Hochenergiemühlen, Planetenmischer, Kneter, Rührwerkskugelmühlen, Rüttelplatten oder Ultraschallgeräte.

Die Tintenformulierungen weisen einen pH-Wert auf von vorzugsweise 2 bis 9, besonders bevorzugt 5 bis 8 und am meisten bevorzugt 6,5 bis 7,5 (bestimmt bei 20°C, beispielsweise mit dem pH-Meter von WTW pH 340i mit Sonde SenTix RJD).

Zur Herstellung einer Anode für Lithiumionen-Batterien kann die Tintenformulierung beispielsweise auf eine Kupferfolie oder einen anderen Stromsammler aufgerakelt werden. Andere Beschichtungsverfahren, wie z.B. Rotationsbeschichtung (Spin-Coating), Rollen-, Tauch- oder Schlitzdüsenbeschichtung, Streichen oder Sprühen, können ebenso verwendet werden.

Die Schichtdicke, das heißt die Trockenschichtdicke der Anodenbeschichtung ist bevorzugt 2 µm bis 500 µm, besonders bevorzugt von 10 µm bis 300 µm.

Das Anodenmaterial wird im Allgemeinen bis zur Gewichtskonstanz getrocknet. Die Trocknungstemperatur liegt bevorzugt zwischen 20°C und 300°C, besonders bevorzugt zwischen 50°C und 150°C. Eine Lithiumionen-Batterie umfasst im Allgemeinen eine erste Elektrode als Kathode, eine zweite Elektrode als Anode, eine zwischen beiden Elektroden angeordnete Membran als Separator, zwei elektrisch leitende Anschlüsse an den Elektroden, ein die genannten Teile aufnehmendes Gehäuse sowie einen Lithiumionen enthaltenden Elektrolyten, mit dem der Separator und die beiden Elektroden getränkt sind, wobei ein Teil der zweiten Elektrode das Anodenmaterial enthält.

Alle zur Herstellung der Lithiumionen-Batterie, wie oben beschrieben, benutzten Stoffe und Materialien sind bekannt. Die Herstellung der Teile der Batterie und ihre Zusammenfügung zur Batterie kann nach den auf dem Gebiet der Batterieherstellung bekannten Verfahren erfolgen, wie beispielsweise in der Patentanmeldung mit der Anmeldenummer DE102015215415.7 beschrieben.

Bei Verwendung der Anodenmaterialien in Lithium-Ionen-Batterien können die Lithium-Ionen-Batterien so konfiguriert sein dass die Anodenmaterialien im vollständig geladenen Zustand der Lithium-Ionen-Batterien nur teilweise lithiiert sind. Bevorzugt ist also, dass das Anodenmaterial, insbesondere die Siliziumpartikel, in der vollständig geladenen Lithium-Ionen-Batterie nur teilweise lithiiert ist. Vollständig geladen bezeichnet den Zustand der Batterie, in dem das Anodenmaterial der Batterie ihre höchste Beladung an Lithium aufweist. Teilweise Lithiierung des Anodenmaterials bedeutet, dass das maximale Lithiumaufnahmevermögen der Siliziumpartikel im Anodenmaterial nicht ausgeschöpft wird. Das maximale Lithiumaufnahmevermögen der Siliziumpartikel entspricht allgemein der Formel Li_{4.4}Si und beträgt somit 4,4 Lithiumatome pro Siliziumatom. Dies entspricht einer maximalen spezifischen Kapazität von 4200 mAh pro Gramm Silizium.

Das Verhältnis der Lithiumatome zu den Siliziumatomen in der Anode einer Lithium-Ionen-Batterie (Li/Si-Verhältnis) kann beispielsweise über den elektrischen Ladungsfluss eingestellt werden. Der Lithiierungsgrad des Anodenmaterials beziehungsweise der im Anodenmaterial enthaltenen Siliziumpartikel ist proportional zur geflossenen elektrischen Ladung. Bei dieser Variante wird beim Laden der Lithium-Ionen-Batterie die Kapazität des Anodenmaterials für Lithium nicht voll ausgeschöpft. Dies resultiert in einer teilweisen Lithiierung der Anode.

Bei einer alternativen, bevorzugten Variante wird das Li/Si-Verhältnis einer Lithium-Ionen-Batterie durch das Zellbalancing eingestellt. Hierbei werden die Lithium-Ionen-Batterien so ausgelegt, dass das Lithiumaufnahmevermögen der Anode vorzugsweise größer ist als das Lithiumabgabevermögen der Kathode. Dies führt dazu, dass in der vollständig geladenen Batterie das Lithiumaufnahmevermögen der Anode nicht voll ausgeschöpft ist, d.h. dass das Anodenmaterial nur teilweise lithiiert ist.

Bei der teilweisen Lithiierung beträgt das Li/Si-Verhältnis im Anodenmaterial im vollständig geladenen Zustand der Lithium-Ionen-Batterie vorzugsweise ≤ 2,2, besonders bevorzugt ≤ 1,98 und am meisten bevorzugt ≤ 1,76. Das Li/Si-Verhältnis im Anodenmaterial im vollständig geladenen Zustand der Lithium-Ionen-Batterie ist vorzugsweise ≥ 0,22, besonders bevorzugt ≥ 0,44 und am meisten bevorzugt ≥ 0,66.

Die Kapazität des Siliziums des Anodenmaterials der Lithium-Ionen-Batterie wird vorzugsweise zu ≤ 50%, besonders bevorzugt zu ≤ 45% und am meisten bevorzugt zu ≤ 40% genutzt, bezogen auf eine Kapazität von 4200 mAh pro Gramm Silizium.

Die Anode wird mit vorzugsweise ≤ 1500 mAh/g, besonders bevorzugt ≤ 1400 mAh/g und am meisten bevorzugt ≤ 1300 mAh/g beladen, bezogen auf die Masse der Anode. Die Anode wird bevorzugt mit mindestens 600 mAh/g, besonders bevorzugt ≥ 700 mAh/g und am meisten bevorzugt ≥ 800 mAh/g beladen, bezogen auf die Masse der Anode. Diese Angaben beziehen sich vorzugsweise auf die vollständig geladene Lithium-Ionen-Batterie.

Der Lithiierungsgrad von Silizium beziehungsweise die Ausnutzung der Kapazität von Silizium für Lithium (Si-Kapazitätsnutzung α) kann beispielsweise bestimmt werden, wie in der Patentanmeldung mit der Anmeldenummer DE 102015215415.7 auf Seite 11, Zeile 4 bis Seite 12, Zeile 25 beschrieben, insbesondere an Hand der dort genannten Formel für die Si-Kapazitätsnutzung α und den ergänzenden Angaben unter den Überschriften "Bestimmung der Delithiierungs-Kapazität β" und "Bestimmung des Si-Gewichtsanteils ω_{Si}" ("incorporated by reference").

Überraschenderweise führt der Einsatz der erfindungsgemäß hergestellten Siliziumpartikel bei der Präparation von wässrigen Tintenformulierungen zu einer geringeren und/oder verzögerten Bildung von Wasserstoff, insbesondere im Vergleich zu den Siliziumpartikeln aus Schritt 1). Dies ist umso überraschender als die Siliziumpartikel aus Schritt 1) und die Siliziumpartikel aus Schritt 2) den gleichen oder den im wesentlich gleichen Sauerstoffgehalt haben können. So setzt der Druckanstieg nach Dispergieren der Siliziumpartikel aus Schritt 2) in Wasser bei pH 7 und 60°C nach vorzugsweise ≥ 45 Minuten, besonders bevorzugt ≥ 60 Minuten ein. Auf Dispergieren der Siliziumpartikel aus Schritt 2) in Wasser bei pH 7 und 60°C beträgt der Druckanstieg 30 Minuten nach Einsetzen des Druckanstiegs vorzugsweise ≤ 1 bar, besonders bevorzugt ≤ 0,8 bar und am meisten bevorzugt ≤ 0,6 bar. Die Messung des Druckanstiegs erfolgt vorzugsweise bei 1 atm oder 1 bar. Eine Methode zur Bestimmung dieser Parameter ist weiter unten unter der Überschrift "Bestimmung der Gasentwicklung anhand wässriger Dispersionen von Siliziumpulvern" beschrieben.

Zudem sind nach dem erfindungsgemäßen Verfahren nicht-aggregierte Siliziumpartikel zugänglich. Ein Zusammenbacken unterschiedlicher Siliziumpartikel kann mit dem erfindungsgemäßen Verfahren unterbunden werden. Sonstige unerwünschte Nebenreaktionen, wie beispielsweise die Bildung von Siliziumsuboxiden oder sonstigen Nebenprodukten, wie Siliziumnitrid, können mit den erfindungsgemäßen Verfahrensbedingungen unterbunden werden.

Vorteilhafterweise kann das erfindungsgemäße Verfahren auf einfache Weise sicher ausgestaltet werden und dabei die Bildung explosionsgefährlicher Mischungen vermieden werden. Es sind homogene, gasblasenfreie Anodenbeschichtungen zugänglich.

Die nachfolgenden Beispiele dienen zur weiteren Erläuterung der Erfindung:

### Bestimmung des Sauerstoffgehalts (O-Gehalt):

Die Bestimmung des Sauerstoffgehalts wurde mit einem Leco TCH-600 Analysator durchgeführt. Die Analyse erfolgte über das Aufschmelzen der Proben in Graphittiegeln unter Inertgasatmosphäre. Detektiert wurde über Infrarotdetektion (drei Messzellen).

### Bestimmung der Partikelgrößen:

Die Messung der Partikelverteilung wurde durch statische Laserstreuung unter Anwendung des Mie-Modells mit einem Horiba LA 950 in einer stark verdünnten Suspension in Wasser durchgeführt. Die ermittelten Partikelgrößenverteilungen sind volumengewichtet.

### Messung und Auswertung von DRIFT Spektren:

Es wurden 35 mg des jeweiligen Si-Pulvers mit 500 mg KBr abgemischt und hiervon ein DRIFT-Spektrum (diffuse reflectance infrared fourier transform spectroscopy), einer gängigen Methode der Infrarotspektroskopie zur Untersuchung von stark absorbierenden oder streuenden Feststoffen, mit einem Gerät der Firma Bruker Optics (Vertex 70 gekoppelt mit XSA-Einheit) aufgenommen, welches mit einem Praying-Mantis-Spiegelsystem der Firma Harrick Scientific Products ausgerüstet war. Gemessen wurde der negative dekadische Logarithmus der "reflectance" in Abhängigkeit von der Wellenzahl.

Zur Auswertung des so erhaltenen DRIFT-Spektrums wurden das Maximum des SiO₂-Signals sowie das Maximum des SiOH-Signals herangezogen. Das Maximum des negativen logarithmischen Reflexionssignals liegt im Falle von SiOH üblicherweise im Bereich von 3300 cm⁻¹ bis 3500 cm⁻¹ und im Falle von SiO₂ üblicherweise im Bereich von 1150 cm⁻¹ bis 1250 cm⁻¹.

Der DRIFT-Parameter ist das Verhältnis des Maximums des negativen logarithmischen Reflexionssignals von SiOH zum Maximum des negativen logarithmischen Reflexionssignals von SiO₂.

### Bestimmung der Gasentwicklung anhand wässriger Dispersionen von Siliziumpulvern:

Es wurden 400 mg des jeweiligen Si-Pulvers in 20 g einer Li-Polyacrylsäure-Lösung (Sokalan PA110S, pH 7,0, 4 Gew.-%ig) dispergiert und in eine dichte und druckstabile Glasflasche (Pressure Reaction Vessel von Andrews Glass Co., 3 oz entsprechend 87 ml Gesamtvolumen) überführt, welche mit einem digitalen Druckaufnehmer versehen war. Anschließend wurde die Glasflasche in einen auf 60°C temperierten Heizmantel eingebracht und der Druck in der Glasflasche gemessen. Die so erhaltenen Messwerte wurden um den Beitrag des Lösungsmittels zum Druck bei 60°C korrigiert.

### Bestimmung der Gasentwicklung anhand der Anodentinten:

Die Bestimmung erfolgte analog zur oben beschriebenen "Bestimmung der Gasentwicklung anhand wässriger Dispersionen von Siliziumpulvern". Es wurden 20 g der jeweiligen Anodentinte in das druckstabile Glasgefäß eingefüllt und in einen zuvor auf 50°C temperierten Heizblock aus Aluminium eingebracht. Die so erhaltenen Messwerte wurden um den Beitrag des Lösungsmittels zum Druck bei 50°C korrigiert.

### Vergleichsbeispiel 1 (VBsp.1):

Herstellen von Si-Partikeln durch Mahlen:
Si-Partikel wurden auf herkömmliche Weise durch Mahlen eines groben Si-Splitts aus der Produktion von Solarsilizium in einer Fließbettstrahlmühle (Netzsch-Condux CGS16 mit 90 m³/h Luft bei 7 bar und einer Vorlauf-Temperatur von 300°C als Mahlgas) hergestellt. Die so erhaltenen Si-Partikel wurden unmittelbar nach dem Mahlen unter Luft abgefüllt und für 3 Monate bei 20°C gelagert. Nach Entnahme der Si-Partikel an Luft wurden die in Tabelle 1 angegebenen analytischen Daten erhalten. Das DRIFT-Spektrum des Produkts von Vergleichsbeispiel 1 ist in Fig. 1 abgebildet.

### Beispiel 2 (Bsp.2):

Thermisches Behandeln von Si-Partikeln:
Es wurden 10 g der in Vergleichsbeispiel 1 durch Mahlen hergestellten Si-Partikel in ein Schiffchen eingewogen und in einem Quarzrohr in den Rohrofen MTF 12/38/400 (Handelsname der Firma Carbolite) überführt. Das Quarzrohr wurde für 10 min mit Argon (Qualität 4.8; 3 ppm Sauerstoff, 5 ppm Wasser) gespült, um eine Inertgasatmosphäre herzustellen. Anschließend wurde der Ofen wie in Tabelle 1 angegeben auf eine bestimmte Temperatur erhitzt und für 4 Stunden bei dieser Temperatur gehalten. Anschließend wurde der Rohrofen unter Inertgasatmosphäre auf Raumtemperatur abgekühlt und das Produkt entnommen. Das Produkt wurde bezüglich Sauerstoffgehalt und Partikelgrößenverteilung sowie mittels DRIFT-Spektroskopie untersucht. Das DRIFT-Spektrum des Produkts von Beispiel 2e ist in Fig. 2 abgebildet.

**Tabelle 1: Temperatur für die thermische Behandlung und analytische Daten der thermisch behandelten Si-Partikel:**

| Si-Partikel | Temperatur der thermischen Behandlung | O-Gehalt^{a)} [Gew.-%] | Partikeldurchmesser | | | DRIFT^{b)} |
|---|---|---|---|---|---|---|
| | | | D₁₀ [µm] | D₅₀ [µm] | D₉₀ [µm] | |
| VBsp.1 | 20°C | 0,34% | 2,5 | 4,8 | 8,2 | 0,231 |
| Bsp.2b | 300°C | 0,35% | 2,6 | 4,9 | 8,1 | 0,176 |
| Bsp.2c | 500°C | 0,38% | 2,5 | 4,8 | 8,3 | 0,084 |
| Bsp.2d | 750°C | 0,38% | 2,5 | 4,8 | 8,2 | 0,065 |
| Bsp.2e | 1000°C | 0,45% | 2,5 | 4,9 | 8,0 | 0,053 |
| VBsp.2f | 1200°C | 0,34% | 2,6 | 4,9 | 8,1 | 0,001 |

| | | | | | | |
|---|---|---|---|---|---|---|
| a) Sauerstoffgehalt der thermisch behandelten Si-Partikel, bezogen auf das Gesamtgewicht der Si-Partikel; b) der Drift-Parameter spiegelt das Verhältnis von SiOH zu SiO₂ in den Si-Partikeln wieder, wie oben unter der Überschrift "Messung und Auswertung von DRIFT Spektren" beschrieben. | | | | | | |

Die erfindungsgemäße thermische Behandlung führt zu keiner Aggregation der Si-Partikel, wie der Vergleich der Partikeldurchmesser von Vergleichsbeispiel 1 und Beispiel 2 zeigt, und auch zu keinem signifikanten Anstieg des Sauerstoffgehalts der Si-Partikel.

Im Falle von Vergleichsbeispiel 2f erfolgte bei der thermischen Behandlung bei 1200°C eine Umsetzung von SiO₂ und Si zu gasförmigem SiO, welches mit dem Inertgasstrom aus dem Produkt ausgetragen wurde, was zu einer Reduktion des Sauerstoffgehalts in den Si-Partikeln führte.

### Austestung der Reaktivität der Si-Partikel in wässerigen Dispersionen:

400 mg Si-Partikel des jeweiligen (Vergleichs)Beispiels wurden in eine Fischer-Porter-Flasche (druckstabiles Glasgefäß, Pressure Reaction Vessel von Andrews Glass Co., 3 oz entsprechend 87 ml Gesamtvolumen) eingewogen, mit 20 g einer wässrigen Li-Polyacrylsäure-Lösung (4 Gew.-%ig) bei pH 7,0 versetzt, für eine Minute einer Ultraschallbehandlung unterzogen, das Druckgefäß verschlossen und anschließend bei 60°C in einem vorgeheizten Aluminium-Heizblock temperiert.

Die Austestungsergebnisse sind in Tabelle 2 aufgeführt.

Der Beginn der Gasentwicklung ist der Zeitpunkt, bei dem der Druck in dem Reaktionsgefäß nach Abzug des Drucks, der sich ohne Zugabe der Si-Partikel aufbaut, zu steigen beginnt.

Der Druckanstieg nach 30 Minuten ist der Druck, welcher sich 30 Minuten nach Einsetzen der Wasserstoffentwicklung eingestellt hat.

Die in Tabelle 2 angegebenen Werte sind Mittelwerte aus Doppelbestimmungen. Die Genauigkeit in Mehrfachbestimmungen liegt bezüglich Beginn der Gasentwicklung bei +/- 2 bis 4 Minuten, bezüglich Druckanstieg bei +/- 0,1 bar.

**Tabelle 2: Gasentwicklung wässriger Si-Partikel Dispersionen:**

| Si-Partikel | Temperatur der thermischen Behandlung | Beginn der Gasentwicklung | Druckanstieg nach 30 Min |
|---|---|---|---|
| VBsp.1 | 20°C | 35 Min | 1,0 bar |
| Bsp.2b | 300°C | 55 min | 0,9 bar |
| Bsp.2c | 500°C | 65 min | 0,7 bar |
| Bsp.2d | 750°C | 78 min | 0,6 bar |
| Bsp.2e | 1000°C | 130 min | 0,4 bar |
| VBsp.2f | 1200°C | 67 min | 1,1 bar |

Die wässrige Dispersion der thermisch nicht behandelten Si-Partikel des Vergleichsbeispiels 1 zeigt ein zügiges Einsetzen von Wasserstoffbildung.

Die durch erfindungsgemäße thermische Behandlung erhaltenen Produkte der Beispiele 2b bis 2e weisen trotz des nahezu gleichen Sauerstoffgehaltes wie Vergleichsbeispiel 1 ein verzögertes Einsetzen der Wasserstoffentwicklung sowie eine reduzierte Rate der Wasserstoffentwicklung in wässriger Suspension auf. Eine thermische Behandlung oberhalb des erfindungsgemäßen Temperaturbereichs (Vergleichsbeispiel 2f) erwies sich sogar im Vergleich zu den thermisch nicht behandelten Si-Partikeln des Vergleichsbeispiels 1 als nachteilig, wie am höheren Druckanstieg erkennbar.

### Austestung der Gasentwicklung in wässrigen Tintenformulierungen:

29,71 g bei 85°C bis zur Gewichtskonstanz getrockneter Polyacrylsäure und 756,60 g deionisiertes Wasser wurden mittels Schüttler (290 1/min) für 2,5 h bis zur vollständigen Lösung der Polyacrylsäure bewegt. Zu der Lösung wurde Lithiumhydroxid Monohydrat portionsweise hinzugegeben, bis der pH-Wert bei 7,0 lag (gemessen mit pH-Meter WTW pH 340i und Sonde SenTix RJD). Die Lösung wurde anschließend mittels Schüttler weitere 4 h durchmischt.

7,00 g der Si-Partikel des jeweiligen (Vergleichs)Beispiels wurden in 12,50 g der neutralisierten Polyacrylsäure-Lösung und 5,10 g deionisiertem Wasser mittels Dissolver bei einer Umlaufgeschwindigkeit von 4,5 m/s für 5 min und von 12 m/s für 30 min unter Kühlung bei 20°C dispergiert. Nach Zugabe von 2,50 g Graphit (Imerys, KS6L C) wurde weitere 30 min bei einer Umlaufgeschwindigkeit von 12 m/s gerührt.

Von der so erhaltenen Anodentinte wurde unmittelbar nach Herstellung die Gasentwicklung durch Messung des Druckaufbaus bestimmt, wie oben beschrieben.

Der Druckaufbau an den Anodentinten wurde für 16 h beobachtet. Die Austestungsergebnisse sind in Tabelle 3 wiedergegeben.

**Tabelle 3: Druckanstieg der wässrigen Anodentinte bei Lagerung:**

| Si-Partikel | Temperatur der thermischen Behandlung | Druck [bar] | | | |
|---|---|---|---|---|---|
| | | Lagerung für 2 h | Lagerung für 4 h | Lagerung für 8h | Lagerung für 16 h |
| VBsp.1 | 20°C | 0,1 bar | 1,1 bar | 2,6 bar | 4,3 bar |
| Bsp.2b | 300°C | 0,1 bar | 1,0 bar | 2,5 bar | 4,1 bar |
| Bsp.2c | 500°C | 0,0 bar | 0,3 bar | 1,7 bar | 2,8 bar |
| Bsp.2e | 1000°C | 0,0 bar | 0,1 bar | 1,2 bar | 1,8 bar |

Die erfindungsgemäßen Tintenformulierungen lassen sich auch nach mehreren Stunden zu homogenen Elektrodenbeschichtungen verarbeiten.

Die Anodentinte mit den Si-Partikeln aus Vergleichsbeispiel 1 neigt nach längeren Standzeiten aufgrund der starken Wasserstoffentwicklung zum Aufschäumen und war nicht zu einer homogenen Elektrodenbeschichtung verarbeitbar.

## Patentansprüche

1. Verfahren zur Herstellung von Siliziumpartikeln, die volumengewichtete Partikelgrößenverteilungen mit Durchmesser-Perzentilen d₅₀ von 1,0 µm bis 10,0 µm und einen Sauerstoffgehalt von 0,1 bis 5 Gew.-%, bezogen auf das Gesamtgewicht der Siliziumpartikel, haben, indem
1) Silizium gemahlen wird unter Bildung von Siliziumpartikeln,
wobei das Mahlen in oxidativer Atmosphäre oder in oxidativem Medium erfolgt und/oder
die mittels Mahlen erhaltenen Siliziumpartikel einer oxidativen Atmosphäre ausgesetzt werden, und
2) die in Schritt 1) erhaltenen Siliziumpartikel bei einer Temperatur von 300°C bis 1100°C in Inertgasatmosphäre oder im Vakuum thermisch behandelt werden.

2. Verfahren zur Herstellung von Siliziumpartikeln gemäß Anspruch 1, **dadurch gekennzeichnet, dass** die Inertgasatmosphäre ein oder mehrere Inertgase ausgewählt aus der Gruppe umfassend Stickstoff und Edelgase, wie Helium, Neon, Argon oder Xenon, enthält.

3. Verfahren zur Herstellung von Siliziumpartikeln gemäß Anspruch 2, **dadurch gekennzeichnet, dass** die Inertgasatmosphäre ≥ 95 Vol.-% Inertgas enthält, bezogen auf das Gesamtvolumen der Inertgasatmosphäre.

4. Verfahren zur Herstellung von Siliziumpartikeln gemäß Anspruch 1 bis 3, **dadurch gekennzeichnet, dass** die oxidative Atmosphäre ein oder mehrere oxidative Gase ausgewählt aus der Gruppe umfassend Kohlendioxid, Stickoxide, Schwefeldioxid, Ozon, Peroxide, Sauerstoff und Wasserdampf enthält.

5. Verfahren zur Herstellung von Siliziumpartikeln gemäß Anspruch 1 bis 4, **dadurch gekennzeichnet, dass** das oxidative Medium ein oder mehrere Flüssigkeiten ausgewählt aus der Gruppe umfassend Wasser, aliphatische oder aromatische Kohlenwasserstoffe, Ester und Alkohole enthält.

6. Verfahren zur Herstellung von Siliziumpartikeln gemäß Anspruch 1 bis 5, **dadurch gekennzeichnet, dass** die in Schritt 2) erhaltenen Siliziumpartikel an ihrer Oberfläche eine Oxidschicht mit einer Schichtdicke von 2 bis 50 nm haben.

7. Verfahren zur Herstellung von Siliziumpartikeln gemäß Anspruch 1 bis 6, **dadurch gekennzeichnet, dass** sich die in Schritt 2) erhaltenen Siliziumpartikel und die in Schritt 1) erhaltenen Siliziumpartikel in ihrem Gehalt an Sauerstoff oder Silizium um ≤ 0,2 Gew.-% unterscheiden, bezogen auf das Gesamtgewicht der Siliziumpartikel.

## Claims

1. Process for producing silicon particles which have volume-weighted particle size distributions having diameter percentiles d₅₀ of from 1.0 µm to 10.0 µm and an oxygen content of from 0.1 to 5% by weight, based on the total weight of the silicon particles, wherein
1) silicon is milled to form silicon particles, with the milling being carried out in an oxidative atmosphere or in an oxidative medium and/or the silicon particles obtained by means of milling being exposed to an oxidative atmosphere, and
2) the silicon particles obtained in step 1) are thermally treated at a temperature of from 300°C to 1100°C in an inert gas atmosphere or under reduced pressure.

2. Process for producing silicon particles according to Claim 1, **characterized in that** the inert gas atmosphere contains one or more inert gases selected from the group consisting of nitrogen and noble gases such as helium, neon, argon or xenon.

3. Process for producing silicon particles according to Claim 2, **characterized in that** the inert gas atmosphere contains ≥ 95% by volume of inert gas, based on the total volume of the inert gas atmosphere.

4. Process for producing silicon particles according to any of Claims 1 to 3,- 2 -**characterized in that** the oxidative atmosphere contains one or more oxidative gases selected from the group consisting of carbon dioxide, nitrogen oxides, sulfur dioxide, ozone, peroxides, oxygen and water vapor.

5. Process for producing silicon particles according to any of Claims 1 to 4, **characterized in that** the oxidative medium contains one or more liquids selected from the group consisting of water, aliphatic or aromatic hydrocarbons, esters and alcohols.

6. Process for producing silicon particles according to any of Claims 1 to 5, **characterized in that** the silicon particles obtained in step 2) have an oxide layer having a layer thickness of from 2 to 50 nm on their surface.

7. Process for producing silicon particles according to any of Claims 1 to 6, **characterized in that** the silicon particles obtained in step 2) and the silicon particles obtained in step 1) differ in respect of their content of oxygen or silicon by ≤ 0.2% by weight, based on the total weight of the silicon particles.

## Revendications

1. Procédé pour la production de particules de silicium qui ont des distributions pondérées en volume de tailles de particules avec des centiles de diamètre d₅₀ de 1,0 µm à 10,0 µm et une teneur en oxygène de 0,1 à 5 % en poids, par rapport au poids total des particules de silicium, par
1) broyage de silicium avec formation de particules de silicium,
le broyage s'effectuant en atmosphère oxydante ou en milieu oxydant et/ou
les particules de silicium obtenues par broyage étant exposées à une atmosphère oxydante, et
2) traitement thermique des particules de silicium obtenues dans l'étape 1), à une température de 300 °C à 1 100 °C sous atmosphère de gaz inerte ou sous vide.

2. Procédé pour la production de particules de silicium selon la revendication 1, **caractérisé en ce que** l'atmosphère de gaz inerte contient un ou plusieurs gaz inertes choisis dans le groupe comprenant l'azote et les gaz rares, tels que l'hélium, le néon, l'argon ou le xénon.

3. Procédé pour la production de particules de silicium selon la revendication 2, **caractérisé en ce que** l'atmosphère de gaz inerte contient ≥ 95 % en volume de gaz inerte, par rapport au volume total de l'atmosphère de gaz inerte.

4. Procédé pour la production de particules de silicium selon l'une quelconque des revendications 1 à 3, **caractérisé en ce que** l'atmosphère oxydante contient un ou plusieurs gaz oxydants choisis dans le groupe comprenant le dioxyde de carbone, les oxydes d'azote, le dioxyde de soufre, l'ozone, les peroxydes, l'oxygène et la vapeur d'eau.

5. Procédé pour la production de particules de silicium selon l'une quelconque des revendications 1 à 4, **caractérisé en ce que** le milieu oxydant contient un ou plusieurs liquides choisis dans le groupe comprenant l'eau, les hydrocarbures aliphatiques ou aromatiques, les esters et les alcools.

6. Procédé pour la production de particules de silicium selon l'une quelconque des revendications 1 à 5, **caractérisé en ce que** les particules de silicium obtenues dans l'étape 2) ont sur leur surface une couche d'oxyde ayant une épaisseur de couche de 2 à 50 nm.

7. Procédé pour la production de particules de silicium selon l'une quelconque des revendications 1 à 6, **caractérisé en ce que** les particules de silicium obtenues dans l'étape 2) et les particules de silicium obtenues dans l'étape 1) diffèrent en leur teneur en oxygène ou silicium de ≤ 0,2 % en poids, par rapport au poids total des particules de silicium.
